# EUROPEAN PATENT SPECIFICATION

(11) **EP 2 474 211 B1**
(45) Date of publication and mention of the grant of the patent: **05.03.2014**
(21) Application number: 10747865.3
(22) Date of filing: 02.09.2010
(51) Int. Cl.: H01L 31/18, H05K 1/02, H05K 3/12, H01L 31/0224

(54) **METHOD FOR CENTERING A PRINT TRACK**
VERFAHREN ZUR ZENTRIERUNG EINER DRUCKSPUR
PROCÉDÉ DE CENTRAGE D'UNE PISTE D'IMPRESSION

(30) Priority: 03.09.2009 IT UD20090150
(43) Date of publication of application: 11.07.2012
(73) Proprietor: Applied Materials, Inc., Santa Clara, CA 95054 (US)
(72) Inventor: GALIAZZO, Marco, I-35127 Padova (IT); BACCINI, Andrea, I-31030 Mignagola di Carbonera (IT); CELLERE, Giorgio, I-36040 Torri Di Quartesolo (IT); DE SANTI, Luigi, I-31027 Spresiano (IT); PASQUALIN, Gianfranco, I-31027 Spresiano (IT); VERCESI, Tommaso, I-31057 Silea (IT)
(74) Representative: Zimmermann & Partner
(86) International application number: PCT/EP2010/062841
(87) International publication number: WO 2011/026880

(56) References cited:
- DE-A1-102007 041 057
- US-A- 4 376 584
- US-A1- 2007 209 697

## Description

### FIELD OF THE INVENTION

The present invention concerns a method for aligning a print track with respect to other print tracks, during a sequence of printing steps, for example silk-screen printing, ink-jet printing, laser printing or others, for example, but not only, for printing conductive tracks on a wafer, a substrate or thin sheet made of silicon, to make a photovoltaic cell.

### BACKGROUND OF THE INVENTION

Prints are known, in particular serigraph prints, in which in one or more printing passes determinate print materials are deposited on a substrate, so as to define corresponding print tracks.

It is also known that this technique is widely applied in processes for making photovoltaic cells, in which, on a print support, for example a wafer, substrate or thin sheet of silicon, various print tracks are printed, for example conductor tracks, the so-called "fingers" and "busbars", in different printing stations disposed in sequence one after the other.

The production of the photovoltaic cells, and consequently the relative printing processes, are subject to very rigid tolerances, and it is therefore necessary to control the position of the print tracks deposited between one station and the next.

One known technique for carrying out this type of control of the position of the print support is to deposit, during the first printing and with the same print material, at least one marker element, advantageously two or more, each in a determinate position on the support, however outside the deposition pattern of the print tracks.

The position of each marker is then verified in the following station, so as to deposit, with desired alignment and positioning, other print tracks complementary to those already made.

Although it is valid as far as the controlling is concerned, this known technique has some disadvantages with regard to the deposit of the marker element: the need to deposit markers on the support could entail a lengthening of the production times, and also the functional characteristics of the signal of the printed conductor tracks can be at least partly compromised.

In fact the physical depositing of the markers on the print support determines, although in a limited way, a reduction in the useful surfaces for the photovoltaic cell, in order to transform solar energy into electric energy.

These disadvantages of the state of the art can be found not only in silk-screen printing techniques but also in other types of printing, for example laser, ink jet or others. Information on relevant prior art can be found in US 2007/209697, DE 102007041057, and US 4376584.

Purpose of the present invention is to perfect a method which allows to deposit a print track in an aligned manner with respect to other print tracks, in a simple, precise and reliable way that overcomes the disadvantages of the state of the art.

The Applicant has devised, tested and embodied the present invention to overcome the shortcomings of the state of the art and to obtain these and other purposes and advantages.

### SUMMARY OF THE INVENTION

The present invention is set forth and characterized in the independent claims, while the dependent claims describe other characteristics of the invention or variants to the main inventive idea.

In accordance with the above purpose, a method according to the present invention is applied to align at least one print track, in which by means of at least a printing station at least first print tracks and at least second print tracks are deposited on the support according to a desired orientation relative to each other.

The method according to the present invention provides at least a first step, in which at least a first print track and at least a marker element are deposited on the support in correspondence with a portion of the support on which at least a part of a second print track is able to be deposited.

According to the invention, the method also comprises at least a second step, in which at least one second print track is deposited on the support, in which said at least one second print track provides a centering interruption consisting in a zone of said second track that is free of print material, said zone being conformed in a manner coordinated with the marker element; the centering interruption is positioned and centered with respect to the marker element, so as to define the positioning and centering of said at least one second print track with respect to the at least one first print track.

With the present invention, it is thus possible to deposit the second print track, in relation to the first print track, with respect to the marker element and at the same time, to contain the marker element inside the second print track.

According to a variant, the first and the second step are formed in sequence with respect to each other.

According to another variant, the first and the second step are effected with an inverse sequence, that is, the second step is effected upstream of the first step.

In this way, all the free surface of the support is functional and is not subjected to any interference from the print material outside the print tracks provided.

The solution according to the present invention is particularly advantageous both in the case where the printing method provides to move the support with respect to the printing heads, and also in the case where the support is always maintained in the same position and the printing station is moved.

Another advantage of the solution according to the present invention is that it supplies at least some data which can, if necessary, be memorized by a control and command unit, in order to control and regulate, on the basis of said data, the subsequent operating steps and/or the subsequent operating cycles.

In particular with the present invention it is possible to obtain precise information on the position of the first print, of the second print, and therefore also of the difference between the two.

This information can be used to control the subsequent printing steps and thus improve the alignment of the prints made.

In one form of embodiment, in which the support is, for example, a silicon wafer to make photovoltaic cells, and the print track is made, for example, with a conductive paste, it is known to deposit a plurality of first tracks substantially parallel to each other, hereafter defined as "fingers", which are connected at the ends at least by the second transverse track, hereafter defined as "busbar".

In this variant solution, the marker elements are deposited on the support in the step when the fingers are printed, in correspondence with the portions of support on which the busbars are then printed. Every busbar provides at least a centering interruption, in this case a hole, comprised in their width and of a deliberately larger conformation than the respective marker elements.

By doing this, at the end of the printing process the marker elements are comprised in the bulk of the busbars without compromising the reception and transformation conditions of the solar energy.

According to a variant, at the end of the second step, a third finishing and collection step is provided which, in correspondence with the common zone between the marker element and the centering interruption, provides to deposit on the busbar a connection material able to completely cover at least the marker element and the centering interruption, advantageously the whole extension of the busbar.

In this way, in particular in the condition in which the print material is a conductive material, the functional breaks in continuity are substantially eliminated on the second print track, due to the free interstice which is defined between the centering interruption and the marker element.

According to another variant, on the same portion of the support on which the second print track is deposited two marker elements are provided. Consequently the second print track provides two corresponding centering interruptions, which are reciprocally disposed to match in centering and positioning with the corresponding marker elements.

In this variant solution, the second track is deliberately orientated with respect to the first tracks, to guarantee for example a substantially orthogonal condition between said print tracks.

According to another variant the marker element has a substantially circular conformation, and consequently the centering interruption has a substantially circular conformation greater than the diameter of the marker element.

According to another variant the marker element has a substantially polygonal shape, ellipsoidal or rather representing an alphanumeric symbol, such as a cross (+), an asterisk (*), a dash (-) or other. Consequently the corresponding centering interruption of the busbar has a correlated shape which is uniformly greater.

According to a further variant, the marker element is made by one or more interruptions of the first print track.

The shape and the size of the marker element can be chosen depending on the different positioning and centering needs of the second print tracks with respect to the first print tracks.

According to another variant, at the end of the two printing steps of the two prints, a control step can be provided, in which for example by means of a dimensional reading of the interstice between the centering interruption and the marker element, the correctness of the centering effected is verified.

### BRIEF DESCRIPTION OF THE DRAWINGS

These and other characteristics of the present invention will become apparent from the following description of some preferential forms of embodiment, given as a non-restrictive example with reference to the attached drawings wherein:
- Figure 1 is a schematic isometric view of a processing system associated with one embodiment of the present invention.
- Figure 2 is a schematic plan view of the system depicted in Figure 1.
- Figure 3 shows schematically a first step of a first form of embodiment of the method according to the present invention;
- Figure 4 shows schematically a second step of the method in Figure 3;
- Figure 5 shows schematically a third step of the method in Figure 3;
- Figure 6 shows schematically a first step of a second form of embodiment of the method according to the present invention;
- Figure 7 shows schematically a second step of the method in Figure 6;
- Figure 8 shows schematically a third step of the method in Figure 6;
- Figure 9 shows schematically a first variant of the present invention;
- Figure 10 shows schematically a second variant of the method in Figure 6;
- Figure 11 shows schematically a third variant of the present invention;
- Figure 12 shows schematically a fourth variant of the present invention;
- Figure 13 is plan view of a surface of a substrate that has a heavily doped region and a patterned metal contact structure formed thereon according to one embodiment of the invention.
- Figure 14a is a close-up side cross-sectional view of a portion of the surface of the substrate shown in Figure 12 according to one embodiment of the invention;
- Figure 14b is a close-up side cross-sectional view of a portion of the surface of the substrate shown in Figure 12 according to a further embodiment of the invention.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION OF A PREFERENTIAL FORM OF EMBODIMENT

With reference to the Figures, three steps of a first form of embodiment of the centering method for a print track according to the present invention are shown.

In this case, the method is applied, to give a non-restrictive example, for the silk-screen printing of print tracks, for example conductive tracks on a substrate 150, for example a wafer, to make photovoltaic cells, only partly shown in the drawings.

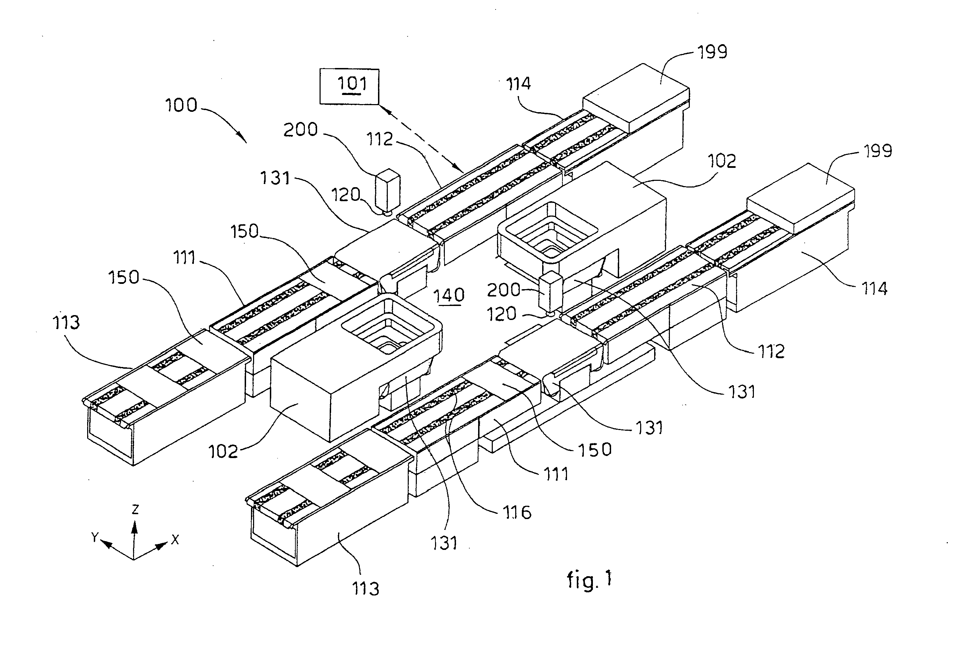

Figure 1 is a schematic isometric view of a substrate processing system, or system 100, according to one embodiment of the present invention. In one embodiment, the system 100 generally includes two incoming conveyors 111, an actuator assembly 140, a plurality of processing nests 131, a plurality of processing heads 102, two outgoing conveyors 112, and a system controller 101. The incoming conveyors 111 are configured in a parallel processing configuration so that each can receive unprocessed substrates 150 from an input device, such as an input conveyor 113, and transfer each unprocessed substrate 150 to a processing nest 131 coupled to the actuator assembly 140. Additionally, the outgoing conveyors 112 are configured in parallel so that each can receive a processed substrate 150 from a processing nest 131 and transfer each processed substrate 150 to a substrate removal device, such as an exit conveyor 114.

In one embodiment, each exit conveyor 114 is adapted to transport processed substrates 150 through an oven 199 to cure material deposited on the substrate 150 via the processing heads 102.

In one embodiment of the present invention, the system 100 is a screen printing processing system and the processing heads 102 include screen printing components, which are configured to screen print a patterned layer of material on a substrate 150.

In another embodiment, the system 100 is an ink jet printing system and the processing heads 102 include ink jet printing components, which are configured to deposit a patterned layer of material on a substrate 150.

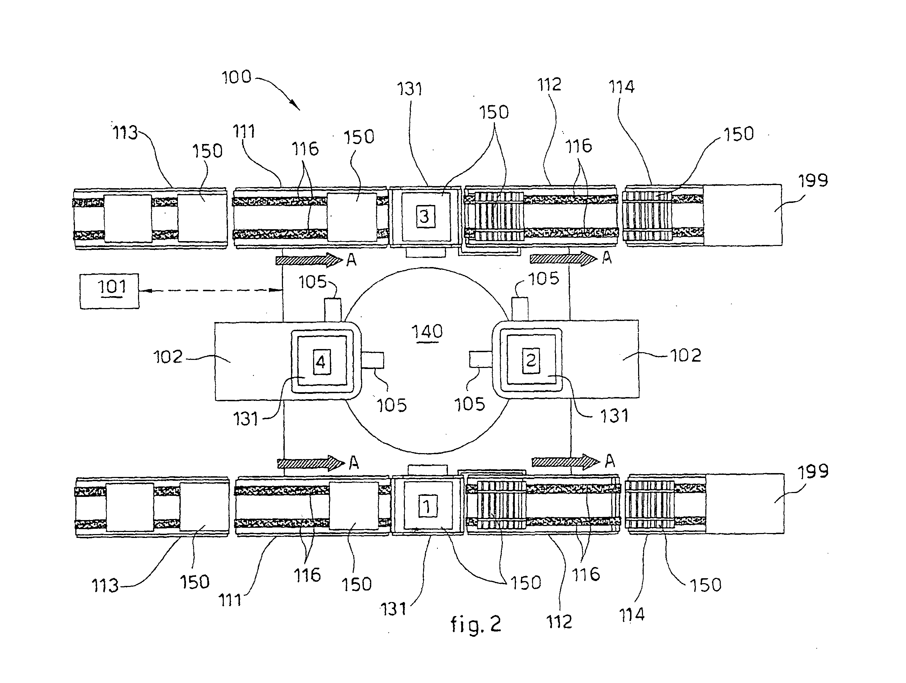

Figure 2 is a schematic plan view of the system 100 depicted in Figure 1. Figures 1 and 2 illustrate the system 100 having two processing nests 131 (in positions "1" and "3") each positioned to both transfer a processed substrate 150 to the outgoing conveyor 112 and receive an unprocessed substrate 150 from the incoming conveyor 111. Thus, in the system 100, the substrate motion generally follows the path "A" shown in Figures 1 and 2. In this configuration, the other two processing nests 131 (in positions "2" and "4") are each positioned under a processing head 102 so that a process (e.g., screen printing, ink jet printing, material removal) can be performed on the unprocessed substrates 150 situated on the respective processing nests 131. Such a parallel processing configuration allows increased processing capacity with a minimized processing system footprint. Although, the system 100 is depicted having two processing heads 102 and four processing nests 131, the system 100 may comprise additional processing heads 102 and/or processing nests 131 without departing from the scope of the present invention.

In one embodiment, the incoming conveyor 111 and outgoing conveyor 112 include at least one belt 116 to support and transport the substrates 150 to a desired position within the system 100 by use of an actuator (not shown) that is in communication with the system controller 101. While Figures 1 and 2 generally illustrate a two belt style substrate transferring system, other types of transferring mechanisms may be used to perform the same substrate transferring and positioning functions without varying from the basic scope of the invention.

In one embodiment, the system 100 also includes an inspection system 200, which is adapted to locate and inspect the substrates 150 before and after processing has been performed. The inspection system 200 may include one or more cameras 120 that are positioned to inspect a substrate 150 positioned in the loading/unloading positions "1" and "3," as shown in Figures 1 and 2. The inspection system 200 generally includes at least one camera 120 (e.g., CCD camera) and other electronic components that are able to locate, inspect, and communicate the results to the system controller 101. In one embodiment, the inspection system 200 locates the position of certain features of an incoming substrate 150 and communicates the inspection results to the system controller 101 for analysis of the orientation and position of the substrate 150 to assist in the precise positioning of the substrate 150 under a processing head 102 prior to processing the substrate 150. In one embodiment, the inspection system 200 inspects the substrates 150 so that damaged or mis-processed substrates can be removed from the production line. In one embodiment, the processing nests 131 may each contain a lamp, or other similar optical radiation device, to illuminate the substrate 150 positioned thereon so that it can be more easily inspected by the inspection system 200.

The system controller 101 facilitates the control and automation of the overall system 100 and may include a central processing unit (CPU) (not shown), memory (not shown), and support circuits (or I/O) (not shown). The CPU may be one of any form of computer processors that are used in industrial settings for controlling various chamber processes and hardware (e.g., conveyors, detectors, motors, fluid delivery hardware, etc.) and monitor the system and chamber processes (e.g., substrate position, process time, detector signal, etc.). The memory is connected to the CPU, and may be one or more of a readily available memory, such as random access memory (RAM), read only memory (ROM), floppy disk, hard disk, or any other form of digital storage, local or remote. Software instructions and data can be coded and stored within the memory for instructing the CPU. The support circuits are also connected to the CPU for supporting the processor in a conventional manner. The support circuits may include cache, power supplies, clock circuits, input/output circuitry, subsystems, and the like. A program (or computer instructions) readable by the system controller 101 determines which tasks are performable on a substrate. Preferably, the program is software readable by the system controller 101, which includes code to generate and store at least substrate positional information, the sequence of movement of the various controlled components, substrate inspection system information, and any combination thereof.

In one embodiment, the two processing heads 102 utilized in the system 100 may be conventional screen printing heads available from Applied Materials Italia Srl which are adapted to deposit material in a desired pattern on the surface of a substrate 150 disposed on a processing nest 131 in position "2" or "4" during a screen printing process. In one embodiment, the processing head 102 includes a plurality of actuators, for example, actuators 105 (e.g., stepper motors or servomotors) that are in communication with the system controller 101 and are used to adjust the position and/or angular orientation of a screen printing mask (not shown) disposed within the processing head 102 with respect to the substrate 150 being printed. In one embodiment, the screen printing mask is a metal sheet or plate with a plurality of holes, slots, or other apertures formed therethrough to define a pattern and placement of screen printed material on a surface of a substrate 150. In one embodiment, the screen printed material may comprise a conductive ink or paste, a dielectric ink or paste, a dopant gel, an etch gel, one or more mask materials, or other conductive or dielectric materials. In general, the screen printed pattern that is to be deposited on the surface of a substrate 150 is aligned to the substrate 150 in an automated fashion by orienting the screen printing mask using the actuators 105 and information received by the system controller 101 from the inspection system 200. In one embodiment, the processing heads 102 are adapted to deposit a metal containing or dielectric containing material on a solar cell substrate having a width between about 125 mm and 156 mm and a length between about 70 mm and 156 mm.

In the particular case, each substrate, or wafer, 150 is suitable to accommodate a plurality of print tracks on its upper surface according to determinate printing patterns, in this case a plurality of first tracks 15, called "fingers", substantially parallel to each other, and second tracks 16, called "busbars", substantially perpendicular and intersecting the first tracks 15, to connect the latter electrically to each other.

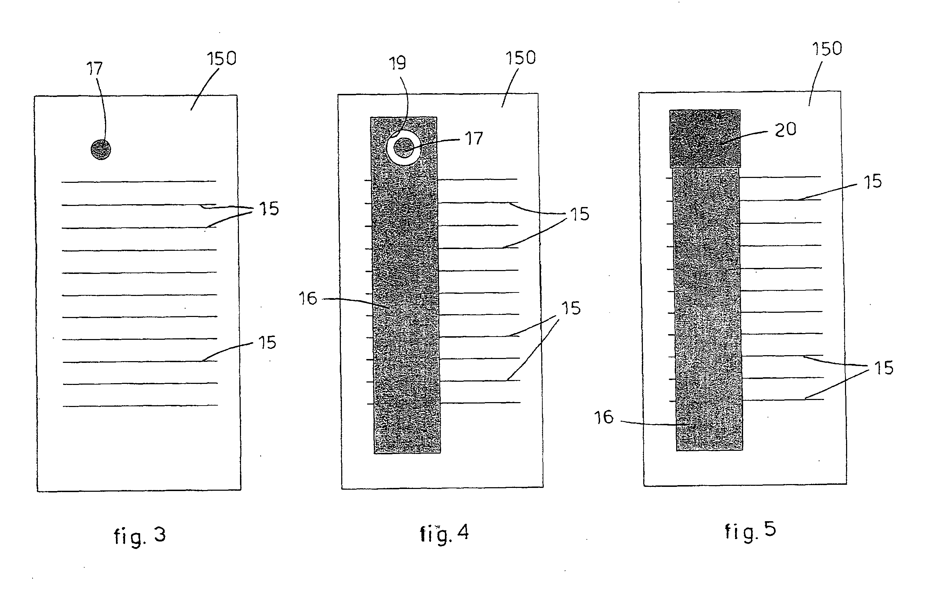

As shown schematically in Figure 3, in a first step of the method according to the present invention a first printing step is effected on the substrate, or wafer, 150, depositing the first tracks 15 according to their printing pattern, by using one of said print heads 102.

In this same step, the method also provides to deposit a marker element 17 on the substrate, or wafer, 150 with the same print material.

The marker element 17, in this case, has a substantially circular shape and is positioned in correspondence with a portion of the substrate, or wafer, 150 on which the second track 16 will be deposited, according to the printing pattern provided.

The second step of the method according to the invention comprises, as shown in Figure 4, the deposit of the second track 16 on the substrate, or wafer, 150.

In particular, the second track 16 is provided with a through centering hole 19 having a correlated shape and greater size with respect to the marker element 17.

In this way, by centering the position of the centering hole 19 with the marker element 17 on the substrate, or wafer, 150, the position where the second track 16 is deposited is unequivocally defined by using the system controller 101, so as to precisely respect the printing pattern provided.

In this step a quality control, based on the detection of the measurement of the free interstice which is defined between the centering hole 19 and the marker element 17, can also be provided, for example by using the inspection system 200 commanded by the system controller 101.

In fact, by detecting the width of the interstice along the whole of its circumferential extension, and verifying that the values detected come within the required tolerances, the print carried out in these two steps of the method is deemed to be satisfactory.

As shown in Figure 5, at the end of the steps to print, position and center the two tracks 15 and 16, a finishing step is provided in which, in correspondence with the zone of the substrate, or wafer, 150 on which the centering hole 19 and the marker element 17 lie, a connection paste 20 is deposited.

The connection paste 20 not only completely covers the centering hole 19 and the marker element 17, but also establishes a structural and functional connection, either on the whole length of the second track 16, or at least in correspondence with the interstice which otherwise would define a break in continuity.

In this way, in particular in the case of conductive tracks, the connection paste 20 is made of conductor material, so as to have maximum yield of electric conduction, and hence maximum yield of the photovoltaic cell consisting of the substrate, or wafer, 150.

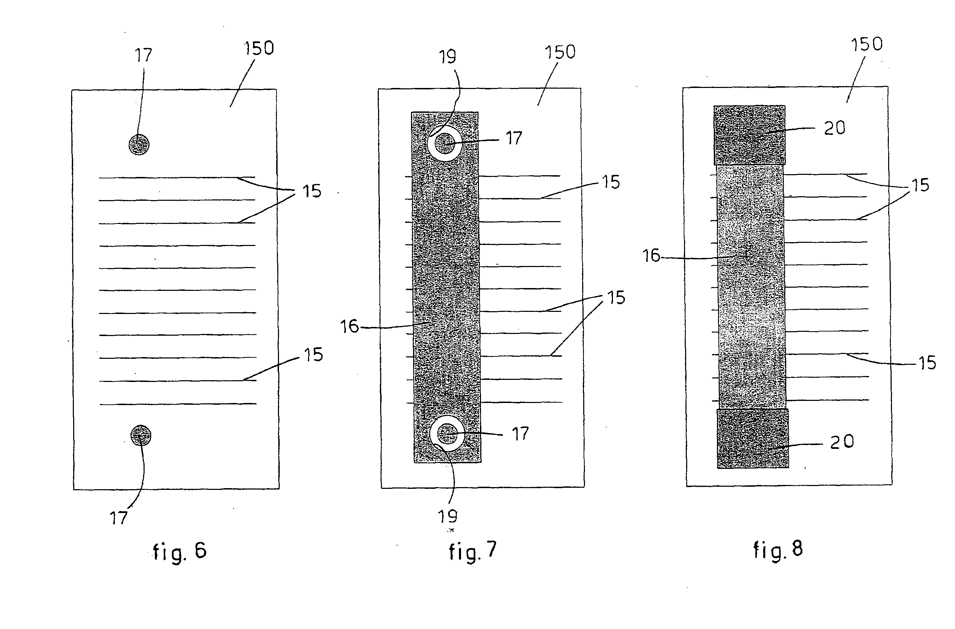

In the form of embodiment shown in Figures 6, 7 and 8, the first step provides to deposit two marker elements 17 for the same second track 16, so as to guarantee a desired alignment of the second track 16, in this case substantially orthogonal with respect to the first tracks 15.

In one embodiment, the alignment could be provided by moving the print head 102 with the actuators 105, according to command signals from the system controller 101.

In this case, the two marker elements 17 are deposited simultaneously in the same printing step, together with the deposit of the first tracks 15.

It also comes within the field of the present invention to provide that a first of the two marker elements 17 is deposited in a first printing substep in which also part of the first tracks 15 are deposited, whereas a second of the two marker elements 17 is deposited in a second printing substep in which the remaining and subsequent first tracks 15, or layers, are deposited.

According to other variants, not shown in the attached drawings, even more than two marker elements 17 can be deposited, each in a respective substep of printing the first tracks 15, or more than one in the same substep of printing the tracks 15, or even during the step of printing the second track 16.

The second track 16 thus comprises two centering holes 19, each conformed to be centered with respect to a relative marker element 17. The reciprocal alignment could be provided, in one embodiment, by using the inspection system 200 under the control of the system controller 101.

The simultaneous centering of the two centering holes 19 with respect to the two relative marker elements 17 allows to position and center in a desired manner the second track 16 with respect to the first tracks 15.

This second form of embodiment too, irrespective of the deposit of the marker elements 17 in a single step or in several substeps, provides a third finishing step, in which the connection paste 20 is deposited in correspondence with each centering hole 19 and the relative marker element 17, to define the desired functional and structural connection.

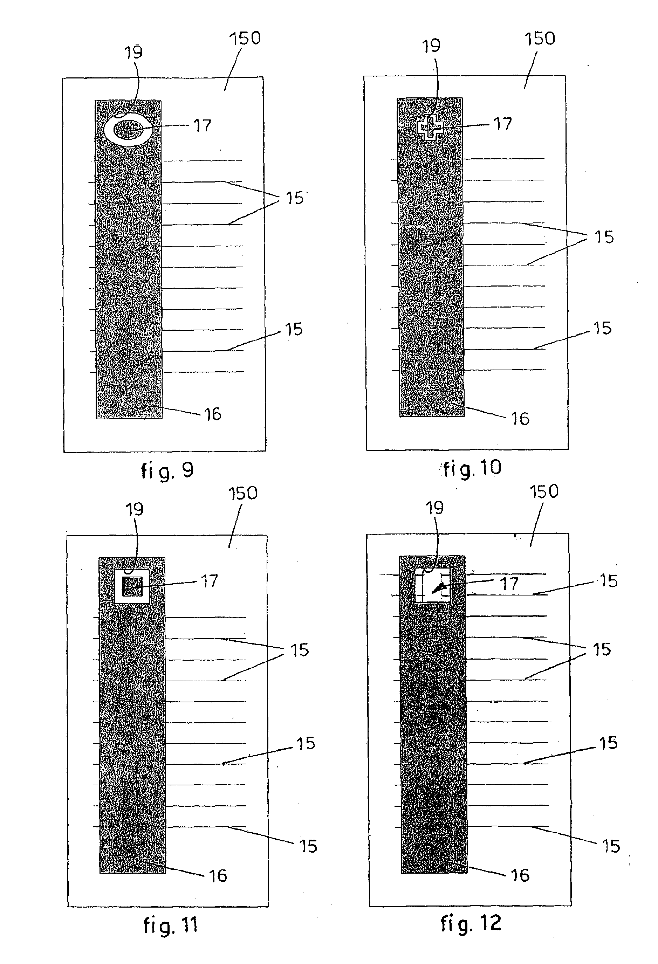

In the variants shown in Figures 9, 10, 11 and 12, four possible conformations of the marker element 17 and consequently of the relative centering hole 19 are shown, purely as an example.

As shown in Figure 9, the marker element 17 has a substantially elliptical conformation, to define by itself a centering, not only on the two axes of the lying plane but also with respect to the orientation of its geometric axes of construction and hence its orientation with respect to the first tracks 15.

In the variant shown in Figure 10, the marker element 17 and the corresponding centering hole 19 are substantially cross-shaped. In this case too, the conformation of the marker element 17 and of the centering hole 19 define a desired centering position and orientation, according to the orientation of the arms of the cross.

In the variant shown in Figure 11, the marker element 17 and the centering hole 19 are quadrangular in shape. In this case too, but with a much more simplified conformation than in the previous variants, the desired centering position and orientation are guaranteed simultaneously.

In the further variant shown in Figure 12, the marker element 17 is provided by an interruption of a line of the first track 15 and the centering hole 19 has, in this not-limiting case, a circular shape so as to perform the centering function.

Double and multiple print of tracks (fingers and busbars) on a substrate 150 is particularly advantageous by using embodiments of the present invention.

Embodiments of the invention provide a solar cell formation process that includes the formation of metal contacts over heavily doped regions 241 that are formed in a desired pattern 230 on a surface of a substrate.

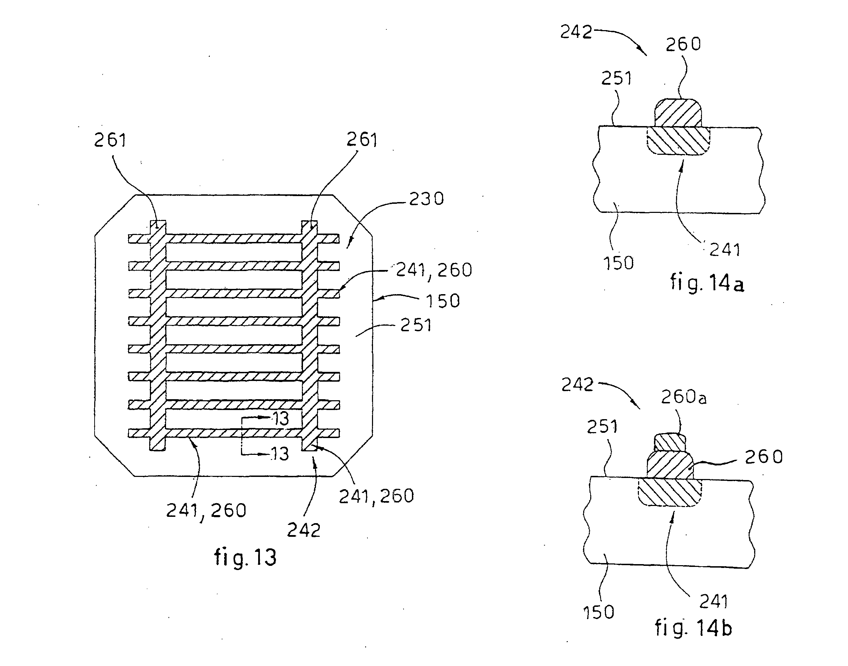

Embodiments of the invention provide that a dopant paste is printed to determine the heavily doped regions 241, a wide metal line defining wide fingers 260 is printed on the heavily doped regions 241, a narrow metal line defining narrow fingers 260a is printed on the wide metal line (see Figures 14a and 14b), and then busbars 261 are printed (Figure 13).

Figure 13 is plan view of a surface 251 of a substrate 150 that has a heavily doped region 241 and a patterned metal contact structure 242 formed thereon, such as fingers 260 and busbars 261.

Figure 14a is side cross-sectional view created at the cross-section line 13-13 shown in Figure 12, and illustrates a portion of the surface 251 having a wide metal finger 260 disposed on the heavily doped region 241.

Figure 14b is side cross-sectional of a further embodiment and illustrates a portion of the surface 251 having a narrow metal finger 260a disposed on the wide metal finger 260.

The metal contact structures, such as fingers 260, 260a and busbars 261, are formed on the heavily doped regions 241 so that a high quality electrical connection can be formed between these two regions. Low-resistance, stable contacts are critical for the performance of the solar cell. The heavily doped regions 241 generally comprise a portion of the substrate 150 material that has about 0.1 atomic % or less of dopant atoms disposed therein. A patterned type of heavily doped regions 241 can be formed by conventional lithographic and ion implantation techniques, or conventional dielectric masking and high temperature furnace diffusion techniques that are well known in the art.

It comes within the field of the present invention to use different materials, both between the first tracks 15 and the second tracks 16, between the tracks 15 and 16 and the marker element 17, between the tracks 15, 16, the marker element 17 and the connection paste 20, according to the different operating and functional requirements of the substrate, or wafer, 150.

It also comes within the field of the present invention to provide that for each second track 16 more than two marker elements 17 are provided with relative centering holes 19.

## Claims

1. Method for centering a print track on a wafer, a substrate or thin sheet made of silicon, to make solar or photovoltaic cells, in which by means of at least a printing station (102) at least a first print track (15) and at least a second print track (16) are deposited on a print substrate (150) according to a determinate orientation, **characterized in that** it comprises at least:
- a first step, in which at least a first print track (15) and at least a marker element (17) are deposited on the substrate (150), wherein said marker element (17) is deposited in correspondence with a portion of said substrate (150) on which at least a second print track (16) is able to be deposited; and
- a second step, in which at least a second print track (16) is deposited on said substrate (150), and in which said second print track (16) provides at least a through centering hole (19) consisting in a zone of said second track (16) that is free of print material, said zone free of print material having a correlated shape and greater size with respect to the marker element (17), said second step providing that said through centering hole (19) is positioned and centered with respect to said marker element (17) to define the positioning and centering of said second print track (16) with respect to said first print track (15).

2. Method as in claim 1, **characterized in that** at the end of the second step a third finishing and connection step is provided, in which on the second print track (16), in correspondence with the common zone between the marker element (17) and the through centering hole (19), a connection material (20) is deposited, able to completely cover at least said marker element (17) and said through centering hole (19).

3. Method as in claim 1 or 2, **characterized in that** the first step provides to deposit two marker elements (17) on the same portion of substrate (150) on which the second print track (16) is deposited.

4. Method as in claim 3, **characterized in that** the second print track (16) provides two through centering holes reciprocally disposed so as to match in centering and positioning with the corresponding two marker elements (17).

5. Method as in any claim hereinbefore, **characterized in that** the marker element (17) is made with a substantially circular conformation, and **in that** the through centering hole (19) is made in a substantially circular conformation bigger than the diameter of said marker element (17).

6. Method as in any claim hereinbefore, **characterized in that** the marker element (17) is made with a substantially polygonal shape.

7. Method as in any claim from 1 to 5, **characterized in that** the marker element (17) is made with a substantially ellipsoidal shape.

8. Method as in any claim from 1 to 5, **characterized in that** the marker element (17) is an interruption of the first print track (15).

9. Method as in any claim hereinbefore, **characterized in that** at the end of the two printing steps of the two print tracks (15, 16), a control step is provided in which, by reading the size of the interstice between the through centering hole (19) and the marker element (17), the correctness of the centering performed is verified.

## Patentansprüche

1. Verfahren zum Zentrieren einer Druckbahn auf einem Wafer, einem Substrat oder dünnen Platte aus Silizium, um Solar- oder Photovoltaikzellen herzustellen, bei dem mittels wenigstens einer Druckstation (102) wenigstens eine erste Druckbahn (15) und wenigstens eine zweite Druckbahn (16) auf einem Drucksubstrat (150) entsprechend einer vorbestimmten Orientierung aufgebracht werden, **dadurch gekennzeichnet, dass** das Verfahren wenigstens umfasst:
- einen ersten Schritt, in dem wenigstens eine erste Druckbahn (15) und wenigstens ein Markierelement (17) auf dem Substrat (150) aufgebracht werden, wobei das Markierelement (17) entsprechend einem Bereich des Substrats aufgebracht wird, auf dem wenigstens eine zweite Druckbahn (16) aufgebracht werden kann; und
- einen zweiten Schritt, in dem wenigstens eine zweite Druckbahn (16) auf dem Substrat (150) aufgebracht wird, und in dem die zweite Druckbahn (16) wenigstens ein Durchgangszentrierloch (19) bereitstellt, das aus in einer Zone der zweiten Bahn besteht, die frei von Druckmaterial ist, wobei die Zone, die frei von Druckmaterial ist, bezüglich dem Markierelement (17) eine korrelierte Form und größere Größe aufweist, wobei der zweite Schritt bereitstellt, dass das Durchgangszentrierloch (19) bezüglich dem Markierelement (17) positioniert und zentriert ist, um die Positionierung und Zentrierung der zweiten Druckbahn (16) bezüglich der ersten Druckbahn (15) festzulegen.

2. Verfahren nach Anspruch 1, **dadurch gekennzeichnet, dass** am Ende des zweiten Schritts ein dritter Vollendungs- und Verbindungsschritt bereitgestellt ist, in dem auf der zweiten Druckbahn (16), in Entsprechung mit der gemeinsamen Zone zwischen dem Markierelement (17) und dem Durchgangszentrierloch (19), ein Verbindungsmaterial (20) aufgebracht wird, das wenigstens das Markierelement (17) und das Durchgangszentrierloch (19) vollständig bedecken kann.

3. Verfahren nach Anspruch 1 oder 2, **dadurch gekennzeichnet, dass** der erste Schritt ein Aufbringen von zwei Markierelementen (17) auf demselben Bereich des Substrates (150) bereitstellt, auf dem die zweite Druckbahn (16) aufgebracht wird.

4. Verfahren nach Anspruch 3, **dadurch gekennzeichnet**, derart dass die zweite Druckbahn (16) zwei Durchgangszentrierlöcher bereitstellt, die wechselseitig angeordnet sind, um in der Zentrierung und der Positionierung mit den entsprechenden zwei Markierelementen (17) übereinzustimmen.

5. Verfahren nach einem der vorstehenden Ansprüche, **dadurch gekennzeichnet, dass** das Markierelement (17) mit einer im Wesentlichen runden Gestalt gebildet ist, und dass das Durchgangszentrierloch (19) mit einer im Wesentlichen runden Gestalt gebildet ist, die größer als der Durchmesser des Markierelements (17) ist.

6. Verfahren nach einem der vorstehenden Ansprüche, **dadurch gekennzeichnet, dass** das Markierelement (17) mit einer im Wesentlichen mehreckigen Form gebildet ist.

7. Verfahren nach einem der Ansprüche 1 bis 5, **dadurch gekennzeichnet, dass** das Markierelement (17) mit einer im Wesentlichen elliptischen Form gebildet ist.

8. Verfahren nach einem der Ansprüche 1 bis 5, **dadurch gekennzeichnet, dass** das Markierelement (17) eine Unterbrechung der ersten Druckbahn (15) ist.

9. Verfahren nach einem der vorstehenden Ansprüche, **dadurch gekennzeichnet, dass** am Ende der zwei Druckschritte der zwei Druckbahnen (15, 16) ein Kontrollschritt bereitgestellt ist, in dem durch Lesen der Größe der Lücke zwischen dem Durchgangszentrierloch (19) und dem Markierelement (17) die Korrektheit der durchgeführten Zentrierung verifiziert wird.

## Revendications

1. Procédé de centrage d'une piste d'impression sur une plaquette, un substrat ou une mince feuille composée de silicone, pour fabriquer des cellules solaires ou photovoltaïques, dans lequel, au moyen d'au moins une station d'impression (102), au moins une première piste d'impression (15) et au moins une deuxième piste d'impression (16) sont déposées sur un substrat d'impression (150) selon une orientation déterminée, **caractérisé en ce qu'**il comprend au moins :
- une première étape, dans laquelle au moins une première piste d'impression (15) et au moins un élément marqueur (17) sont déposés sur le substrat (150), ledit élément marqueur (17) étant déposé en correspondance à une partie dudit substrat (150) sur laquelle au moins une deuxième piste d'impression (16) est apte à être déposée ; et
- une deuxième étape, dans laquelle au moins une deuxième piste d'impression (16) est déposée sur ledit substrat (150), et dans laquelle ladite deuxième piste d'impression (16) présente au moins un trou de centrage traversant (19) consistant en une zone de ladite deuxième piste (16) qui est exempte de matière d'impression, ladite zone exempte de matière d'impression ayant une forme corrélée et une taille supérieure par rapport à l'élément marqueur (17), ladite deuxième étape faisant en sorte que ledit trou de centrage traversant (19) soit positionné et centré par rapport audit élément marqueur (17) afin de définir le positionnement et le centrage de ladite deuxième piste d'impression (16) par rapport à ladite première piste d'impression (15).

2. Procédé selon la revendication 1, **caractérisé en ce que**, à la fin de la deuxième étape, une troisième étape de finition et de raccordement est prévue, dans laquelle, sur la deuxième piste d'impression (16), en correspondance à la zone commune entre l'élément marqueur (17) et le trou de centrage traversant (19), une matière de raccordement (20) est déposée, apte à recouvrir entièrement au moins ledit élément marqueur (17) et ledit trou de centrage traversant (19).

3. Procédé selon la revendication 1 ou 2, **caractérisé en ce que** la première étape fait en sorte de déposer deux éléments marqueurs (17) sur la même partie de substrat (150) sur laquelle la deuxième piste d'impression (16) est déposée.

4. Procédé selon la revendication 3, **caractérisé en ce que** la deuxième piste d'impression (16) présente deux trous de centrage traversants disposés réciproquement de façon à s'accorder en centrage et en positionnement avec les deux éléments marqueurs (17) correspondants.

5. Procédé selon l'une quelconque revendication précédente, **caractérisé en ce que** l'élément marqueur (17) est constitué avec une configuration sensiblement circulaire, et **en ce que** le trou de centrage traversant (19) est constitué selon une configuration sensiblement circulaire plus grande que le diamètre dudit élément marqueur (17).

6. Procédé selon l'une quelconque revendication précédente, **caractérisé en ce que** l'élément marqueur (17) est constitué avec une forme sensiblement polygonale.

7. Procédé selon l'une quelconque des revendications 1 à 5, **caractérisé en ce que** l'élément marqueur (17) est constitué avec une forme sensiblement ellipsoïdale.

8. Procédé selon l'une quelconque des revendications 1 à 5, **caractérisé en ce que** l'élément marqueur (17) est une interruption de la première piste d'impression (15).

9. Procédé selon l'une quelconque revendication précédente, **caractérisé en ce que**, à la fin des deux étapes d'impression des deux pistes d'impression (15, 16), une étape de contrôle est prévue, dans laquelle, par lecture de la taille de l'interstice entre le trou de centrage traversant (19) et l'élément marqueur (17), l'exactitude du centrage effectué est vérifié.
